# EUROPÄISCHE PATENTSCHRIFT

(11) **EP 2 294 359 B1**
(45) Veröffentlichungstag und Bekanntmachung des Hinweises auf die Patenterteilung: **02.08.2017**
(21) Anmeldenummer: 09769333.7
(22) Anmeldetag: 25.06.2009
(51) Int. Cl.: G01C 19/5712, G01C 19/574

(54) **MIKRO-GYROSKOP**
MICRO GYROSCOPE
MICRO-GYROSCOPE

(30) Priorität: 27.06.2008 DE 102008002748
(43) Veröffentlichungstag der Anmeldung: 16.03.2011
(73) Patentinhaber: Maxim Integrated GmbH, 8403 Lebring (AT)
(72) Erfinder: ROCCHI, Alessandro, I-57013 Rosignano Solvay (LI) (IT)
(74) Vertreter: Bergmeier, Werner
(86) Internationale Anmeldenummer: PCT/EP2009/058000
(87) Internationale Veröffentlichungsnummer: WO 2009/156485

(56) Entgegenhaltungen:
- EP-A1- 1 832 841
- WO-A1-98/17973
- WO-A1-2006/023174
- WO-A1-2006/034706
- WO-A1-2006/126253
- WO-A2-2005/098358
- DE-A1- 19 928 307
- DE-A1-102006 046 772
- US-A1- 2002 189 352

## Beschreibung

Die vorliegende Erfindung betrifft ein Mikro-Gyroskop gemäß Oberbegriff des Anspruches 1.

Mikro-Gyroskope werden in der Regel zur Ermittlung einer Drehbewegung um eine Achse in einem x-y-z-Koordinatensystem verwendet. Um Drehbewegungen des Systems um jede der drei Achsen ermitteln zu können, sind daher drei derartige Mikro-Gyroskope erforderlich. Dies ist kostenintensiv und aufwändig in der Steuerung bzw. Auswertung der Daten.

Um ein dreidimensionales Gyroskop schaffen zu können, bei welchem Drehungen in allen drei Achsen festgestellt werden können, hat D. Wood et al. in dem Artikel "A monolithic silicon gyroscope capable of sensing about three axes simultaneously" 1996 vorgeschlagen, ein Gyroskop zu schaffen, welches ringförmig um einen zentralen Anker angeordnete oszillierende Massen aufweist, welche sowohl Kipp- als auch eine Drehbewegungen aufgrund auftretender Corioliskräfte feststellen kann. Nachteilig hierbei ist, dass die Fertigung eines solchen Sensors ebenso wie der Antrieb der bewegten Massen schwierig bzw. nicht realisierbar ist. Die Ausführungen von D. Wood et al. blieben daher lediglich theoretischer Art.

In dem Artikel "Design and dynamics of an innovative micro-gyroscope against coupling effects" von Nan-Chyuan Tsai wurde ebenfalls ein 3D-Gyroskop vorgeschlagen. Nachteilig hierbei ist, dass eine innere Platte und ein äußerer Ring sowie vier bewegte Massen vorhanden sind. Die Auslenkungen, insbesondere der inneren Scheibe, sind nur schwierig zu ermitteln. Aus der WO-A1-2006/034706 ist ein Drehratensensor zur Erfassung von Drehraten um zwei Achsen bekannt. Der Sensor hat einen relativ großen Flächenbedarf und ist dennoch nicht geeignet drei Dimensionen zu erfassen.

Auch ist die Genauigkeit der Erfassung durch viele zueinander bewegte Bauteile nicht einfach zu erreichen.

In den Druckschriften WO-A2-2005/098358, DE-A1-199 28 307, WO-A1-2006/023174, WO-A1-2006/126253 und EP-A1-1 832 841 sind Ringstrukturen von Drehratensensoren offenbart, die entweder auch nur zweidimensionale Bewegungen erfassen können oder die einzelnen Bauteile derart ineinander geschachtelt haben, dass die präzise Herstellung für eine hohe Erfassungsgenauigkeit sehr aufwändig ist.

Aufgabe der vorliegenden Erfindung ist es, einen zu vertretbaren Kosten herstellbaren 3D-Mikro-Gyro-Sensor mit hoher Erfassungsgenauigkeit zu schaffen.

Die Aufgabe wird gelöst mit einem Mikro-Gyroskop mit den Merkmalen des Anspruches 1. Vorteilhaft ist es hierbei, dass an dem Anker sowohl die oszillierenden Massen als auch, jedenfalls mittelbar, die zumindest eine weitere Masse gelagert ist. Die Erfassung der Auslenkungen durch die Corioliskräfte erfolgt durch Sensorelemente, welche den oszillierenden Massen und den weiteren Massen zugeordnet sind. Es werden damit Schwenkbewegungen und/oder Drehbewegungen der Massen erfasst. Der Anker kann einteilig sein oder auch aus verschiedenen Teilen bestehen. Bei einem mehrteiligen Anker kann es sein, dass jede der oszillierenden Massen an einem dieser Teilanker angeordnet ist. Wesentlich ist, dass die oszillierenden Massen einerseits eine radiale Bewegung weg von und hin zu dem oder den Anker(n) erlauben und andererseits auch eine Kippbewegung und eine Drehbewegung um den Anker ermöglichen. Hierdurch ist es einerseits möglich, dass die oszillierenden Massen als Antriebsmassen einsetzbar sind und andererseits Bewegungen aufgrund der Corioliskräfte auf die entsprechenden Massen übertragen werden können. Damit ist es möglich Drehungen des Gyroskops, d.h. insbesondere des Substrats, um eine x-, y- oder z-Achse zusammen mit den jeweils zugeordneten Sensorelementen feststellen zu können.

Vorzugsweise und nicht einschränkend sind die Sensorelemente zum Erfassen der Auslenkung der oszillierenden Massen unterhalb der oszillierenden Massen, d.h. zwischen den oszillierenden Massen und dem Substrat angeordnet. Die Sensorelemente können dabei, wenn sie beispielsweise kapazitiver Art sind, durch Änderung der Spannungen eine Auslenkung der oszillierenden Massen feststellen. Das Sensorelement zum Erfassen einer Drehbewegung der weiteren Masse kann entweder durch ebenfalls mit der weiteren Masse in Verbindung stehende kapazitive Sensoren oder durch andere gleichwertige Sensoren festgestellt werden, welche eine Abstandsänderung zu einem feststehenden Element dieses Sensorelementes feststellt.

Besonders vorteilhaft ist es, wenn die weitere Masse die oszillierenden Massen als ein Ring oder Rahmen umgibt. Hierdurch ist gleichzeitig eine Befestigung und Abstützung der oszillierenden Masse an ihrem äußeren Umfang an der weiteren Masse ermöglicht. Es entsteht hierdurch ein stabiles System, welches auch gegenüber äußeren Schockeinflüssen stabil ist.

Ist die weitere Masse mit Biegefedern an dem Substrat befestigt, so kann sich diese auch entsprechend abstützen, um Stöße, welche von außen auf das System einwirken, dämpfen zu können und Fehlmessungen zu vermeiden.

Erlauben die Biegefedern eine Rotation der weiteren Masse um die z-Achse, so sind sie dazu geeignet, entsprechende Corioliskräfte, welche eine Rotation der weiteren Masse bewirken, sehr einfach auf eine Auslenkung der weiteren Masse umzusetzen, ohne dem hinderlich zu sein.

Vorzugsweise ist der eine Anker zentral angeordnet. Dies erlaubt eine gute und gleichmäßige Auslenkung in allen vier Drehachsen.

Sind die oszillierenden Massen an dem zentralen Anker befestigt, so ist ebenfalls ein gleichmäßiges und symmetrisches System zur guten und gleichmäßigen Erfassung aller drei Drehmöglichkeiten gegeben.

In einer besonders vorteilhaften Ausgestaltung der Erfindung ist zwischen den oszillierenden Massen und dem zentralen Anker eine Zentralplatte angeordnet. Die Zentralplatte kann die Schwenk- und Drehbarkeit der oszillierenden Massen sowie der daran angeordneten weiteren Masse(n) besonders gut realisiert werden. Ist die Zentralplatte an dem Anker nach Art eines Kardangelenkes befestigt, so erlaubt diese Befestigung eine Schwenkbewegung der Massen um die x- und y-Achse.

Um die oszillierenden Massen in radialer Richtung beweglich auszugestalten, ist es vorteilhaft, wenn die oszillierenden Massen mittels Federn an der Zentralplatte oder bei Fehlen der Zentralplatte an dem Anker direkt und/oder mittels weiterer Federn an den weiteren Massen befestigt sind. Die oszillierenden Massen sind damit in der Lage, in der x-y-Ebene hin- und herzuschwingen. Vorzugsweise sind die Federn derart ausgestaltet, dass sie eine Bewegung der oszillierenden Massen in z-Richtung vermeiden, insbesondere dann, wenn die oszillierenden Massen an der Zentralplatte, welche ihrerseits wieder beweglich gelagert ist, befestigt sind. Sind die Federn relativ starr in z-Richtung, so ist eine Auslenkung der oszillierenden Massen in z-Richtung nur zusammen mit der elastisch gelagerten Zentralplatte und der in dieser Richtung fest mit den oszillierenden Massen verbundenen weiteren Massen möglich.

Um ein gleichmäßiges Schwingen der oszillierenden Massen zu ermöglichen, sind vorteilhafterweise Synchronisierfedern vorgesehen, welche die oszillierenden Massen miteinander verbinden. Die Synchronisierfedern erlauben einerseits eine gewisse Elastizität in Umfangsrichtung um den Anker, um zu erlauben, dass die oszillierenden Massen sich bei ihrer linearen Radialbewegung etwas voneinander entfernen. Andererseits behindern sie aber die oszillierenden Massen, sofern diese dazu neigen sollten, nicht gleichmäßig und gleichzeitig nach außen und innen zu schwingen.

Sind die oszillierenden Massen und die weitere Masse und/oder die Zentralplatte drehbar um die z-Achse gelagert, insbesondere mit entsprechenden Federn, so ist es möglich, dass die oszillierenden Massen und die weitere Masse eine Drehbewegung aufgrund einer Corioliskraft, welche um die z-Achse wirkt, anzuzeigen, indem sich diese Massen in die entsprechende Richtung bewegen. Die Drehbewegung kann mittels Sensorelementen sodann erfasst und ausgewertet werden.

Zum Antrieb der oszillierenden Massen sind vorzugsweise Elektroden, insbesondere Gabel- oder Kammelektroden, vorgesehen. Diese Elektroden regen die oszillierenden Massen zur jeweiligen Schwingung an und bewirken eine gezielte Schwingung mit einer vorbestimmten Frequenz.

Weitere Vorteile der Erfindung und weitere erfinderische Gedanken sind in der nachfolgenden Beschreibung von Ausführungsbeispielen dargelegt. Es zeigt:
- **Figur 1**: einen Überblick über eine mögliche Ausgestaltung der Erfindung,
- **Figur 2**: das Arbeitsprinzip des Gyroskops gemäß Figur 1,
- **Figur 3**: ein weiteres Ausführungsbeispiel der Erfindung,
- **Figur 4**: die Antriebsstruktur der Ausführung gemäß Figur 3,
- **Figur 5**: die Zentralplatte der Ausführung gemäß Figur 3 und
- **Figur 6**: den äußeren Rahmen der Ausführung gemäß Figur 3.

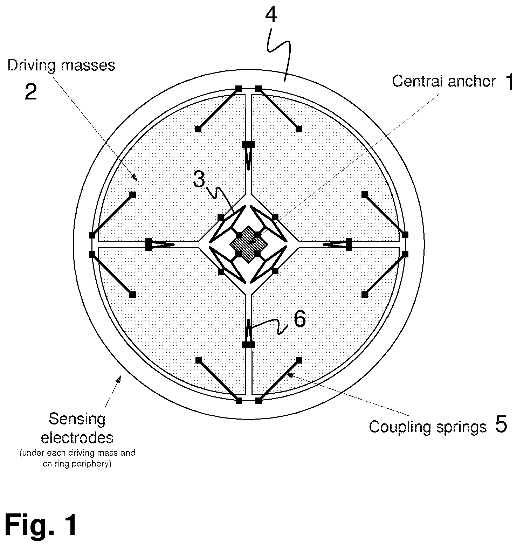

Figur 1 zeigt ein mögliches Ausführungsbeispiel eines erfindungsgemäßen Mikro-Gyroskops. In einem zentralen Anker 1, welcher an einem in der Zeichenebene liegenden Substrat befestigt ist, sind vier oszillierende Antriebsmassen 2 angeordnet. Die Massen 2 sind mittels Federn 3 an dem Anker 1 befestigt, so dass die Federn einerseits um den Anker 1 herum in der Zeichenebene drehbar sind, andererseits aber auch um eine in der Zeichenebene liegende Drehachse schwenken können. Die Federn 3, welche hier symbolisch rautenförmig dargestellt sind, ermöglichen darüber hinaus, dass sich die Antriebsmassen 2 radial von dem zentralen Anker 1 weg und wieder zurück zu diesem hin bewegen können. Die Antriebsmassen oszillieren somit in radialer Richtung. Hierzu sind nicht dargestellte Antriebselemente, beispielsweise Antriebselektroden, vorgesehen, welche die Massen 2 in oszillierender Bewegung halten. Die Antriebsmassen 2 sind von einer weiteren Masse, hier einem Ring 4, umgeben. Der Ring 4 ist mit den Massen 2 mittels Federn 5 verbunden. Die Federn 5 sind derart angeordnet und ausgerichtet, dass sie einerseits die oszillierende Bewegung der Massen 2 möglichst wenig behindern, andererseits aber auch eine Kopplung des Rings 4 mit den Antriebsmassen 2 in Rotations- und in Schwenkrichtung bewirken. Werden die Antriebsmassen 2 und der Ring 4 aufgrund einer auftretenden Corioliskraft ausgelenkt, so sind sowohl die oszillierenden Massen als auch die weitere Masse in Form des Rings 4 miteinander gekoppelt und erfahren die gleiche Auslenkung. Die Federn 5 sind dementsprechend so ausgebildet, dass sie in radialer Richtung nachgiebig, in den anderen Richtungen jedoch steif sind. Sie können aber in einer anderen Ausführung auch so ausgebildet sein, dass sie die Kippbewegung der oszillierenden Massen zwar erlauben, nicht aber der weiteren Masse bzw. des Rings 4. Die Federn 5 sind in diesem Falle außer in Drehrichtung um die z-Achse weich ausgebildet. Die oszillieren Massen bewegen sich in diesem Falle bei einer Kippbewegung um die x- oder y-Achse relativ zu dem Ring 4 und der Ring 4 bleibt in seiner x-y-Ebene ungekippt stehen.

Zwischen den vier Antriebsmassen 2 sind jeweils Synchronisierfedern 6 angeordnet. Die Synchronisierfedern 6 sind derart ausgebildet, dass sie ein synchrones Schwingen der Antriebsmassen 2 unterstützen. Sie erlauben somit eine gewisse Dehnung bei einer Vergrößerung des Spaltes zwischen zwei Antriebsmassen 2 bei einem radial nach außen Wandern der Antriebsmassen 2 und eine Verringerung des Spaltes, wenn die Antriebsmassen 2 wieder Richtung Zentrum bewegt werden. Andererseits sind die Synchronisierfedern allerdings steif, wenn die Antriebsmassen 2 versuchen würden, ungleichmäßig zu oszillieren.

Unterhalb der Antriebsmassen 2 und im Bereich des Rings 4, insbesondere an dessen Peripherie, sind Sensorelektroden angeordnet, welche eine Abstandsveränderung feststellen können. Diese Sensorelektroden bestehen beispielsweise aus kapazitiv wirkenden Platten, welche eine Drehbewegung des Systems um den zentralen Anker 1 oder eine Kippbewegung um eine der in der Zeichenebene liegenden Achsen feststellt.

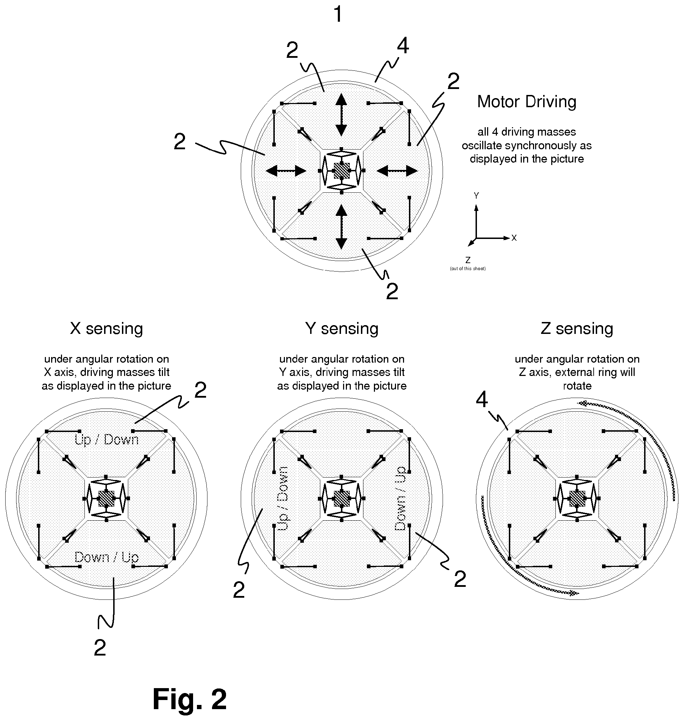

Figur 2 zeigt die verschiedenen Bewegungsrichtungen des Mikro-Gyroskops aus Figur 1. Der Antrieb erfolgt durch eine oszillierende Bewegung der vier Antriebsmassen 2 in radialer Richtung ausgehend vom Zentralanker 1. Die Antriebsmassen 2 oszillieren synchron in der Zeichenebene, d.h. in der x-y-Ebene. Die Federn 3, 5 und 6 stabilisieren die Antriebsmassen 2 einerseits und erlauben andererseits eine leichtgängige oszillierende Bewegung. Der Ring 4 bleibt in dieser Ausgangssituation unbewegt.

Tritt eine Corioliskraft auf, welche eine Drehbewegung des Systems um die x-Achse bewirkt, so bewegen sich die oben und unten dargestellten Massen 2 nach oben bzw. unten. Auch der Ring 4 kann in dieser Richtung bewegt werden, wenn die Federn 5 dementsprechend ausgebildet sind, d.h. es schwenkt das gesamte System bestehend aus Antriebsmassen 2 und dem Ring 4 nach oben bzw. unten um die x-Achse. Bei einer anderen Ausführung der Federn 5 schwenken jedoch nur die Massen 2 nach oben und unten und der Ring 4 bleibt ungeschwenkt in der Zeichenebene stehen. Wie in dem mittleren Bild dargestellt, bewegt sich bei einer Corioliskraft, welche eine Drehbewegung des Systems um die y-Achse bewegt, die links und rechts dargestellte Masse 2 zusammen mit oder bei entsprechender Ausgestaltung der Federn 5 auch ohne dem Ring 4 um die y-Achse und schwenken damit nach oben bzw. unten.

Soll eine Corioliskraft festgestellt werden, welche eine Drehung des Systems um die aus der Zeichenebene herausragende z-Achse bewirkt, so dreht sich das System um den Zentralanker 1. Sowohl die Massen 2 als auch der Ring 4 werden dabei durch die Steifigkeit der Federn 5 in dieser Richtung gemeinsam um die z-Achse bewegt.

Mit dem erfindungsgemäßen System ist es relativ einfach möglich, Bewegungen des Mikro-Gyroskops in drei Drehachsen x, y und z festzustellen. Die jeweiligen Auslenkungen werden durch Sensorelektroden, welche im Bereich der ausgelenkten Massen angeordnet sind, festgestellt.

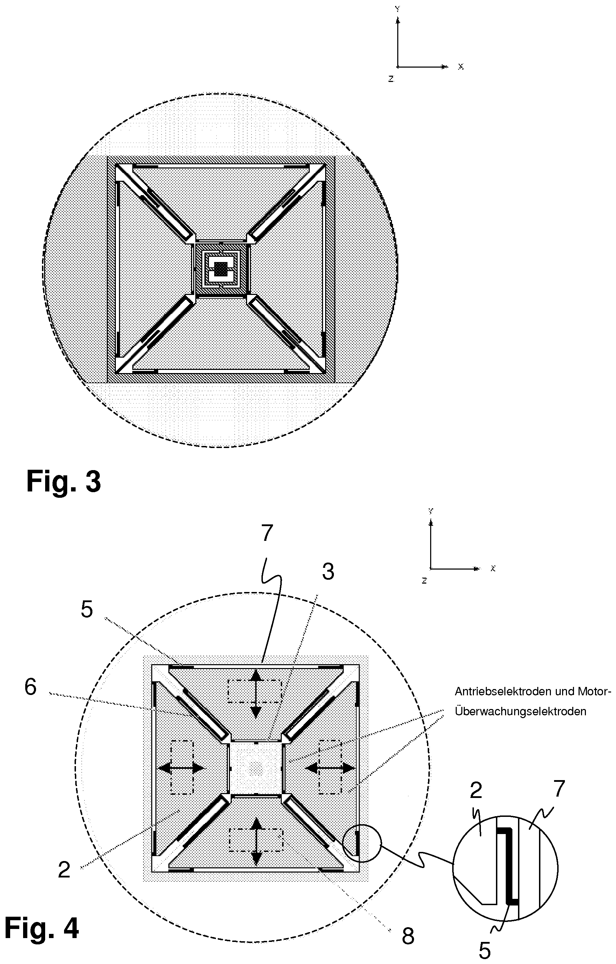

In Figur 3 ist ein weiteres Ausführungsbeispiel der vorliegenden Erfindung dargestellt. Es zeigt einen erfindungsgemäßen Sensor im Überblick. Der vorgeschlagene Sensor ist ein 3D-Miniatur-Gyroskop, welches in der Lage ist, Drehbeschleunigungen um die drei Achsen x, y und z festzustellen. Der Sensor ist in bekannter Micro-Machining-Technik hergestellt. Ein wesentliches Merkmal der Erfindung sind vier synchron angetriebene Massen 2, welche unter dem Einfluss externer Drehgeschwindigkeiten ihre Bewegung verändern. Diese Bewegungsänderung wird von Elektroden mittels Kapazitätsänderungen festgestellt. Die synchronen Massen 2 erlauben eine einzige Antriebskontrollschleife in der zugehörigen Elektronik, wodurch ein einfaches und billiges System resultiert. Um die Kosten des Sensorsystems, d.h. des Mikro-Gyroskops, zusammen mit der Auswerteelektronik zu verringern, kann durch das erfindungsgemäße Sensordesign ein Time-Sharing beim Abfragen der Sensorelektroden vorgenommen werden. Die Winkelgeschwindigkeiten um die x-, y- und z-Achse können durch denselben und einzigen Kanal ausgelesen werden, wobei die einzelnen Winkelgeschwindigkeiten nacheinander in verschiedenen Zeitbereichen abgefragt werden. Hierdurch ist die gesamte Auswerteelektronik wesentlich kostengünstiger herzustellen, ohne dass die Genauigkeit des Systems verloren geht. In den folgenden Figuren werden Einzelheiten des Sensors näher beschrieben.

In Figur 4 ist die Antriebsstruktur des Sensors dargestellt. Die vier Antriebsmassen 2 werden oszillierend in radialer Richtung durch nicht dargestellte Antriebselemente, wie beispielsweise Elektroden, in hoher Frequenz angetrieben. Jede der Antriebsmassen ist mit Federn 3, 5 und 6 befestigt. Die Feder 3 ist bei diesem Ausführungsbeispiel an einer später beschriebenen Zentralplatte an einer Kontaktstelle befestigt. Diese Kontaktstelle ist zentral zwischen zwei weiteren Befestigungsstellen der Feder 3 angeordnet, welche an der Masse 2 befestigt sind. Hierdurch entsteht ein System, welches eine gewisse Elastizität in radialer Richtung aufweist. Außerdem ist das System elastisch bzgl. Drehbewegungen um die z-Achse. Die Masse 2 ist weiterhin befestigt über zwei Federn 5, welche z-artig ausgebildet sind und die Masse 2 an einem äußeren Rahmen 7 befestigt. Durch die Ausgestaltung dieser beiden Federn 5 wird wiederum eine elastische Lagerung der Masse 2 in radialer Richtung bewirkt, so dass die Masse 2 sich oszillierend bewegen kann. Andererseits können die Federn 5 alternativ so ausgestaltet sein, dass sie eine starre oder eine weiche Kopplung der Masse 2 mit dem Rahmen 7 in Bezug auf Kippbewegungen um die x- oder y-Achse bewirken. Bzgl. Drehbewegungen um die z-Achse sind die Massen 2 und der Rahmen 7 weitgehend starr über die Federn 5 miteinander verbunden. Treten Kräfte auf, welche das System um die x-, y- oder z-Achse bewegen, so kann das System der Masse 2 und des Rahmens 7 starr miteinander gekoppelt sein, so dass beide gleichermaßen ausgelenkt werden. Die starre Kopplung kann jedoch auch so ausgeführt sein, dass sie nur eine Drehbewegung um die z-Achse betrifft. Bei einer Bewegung um die x- oder y-Achse kippt in dieser Alternative nur die bewegten Massen 2, nicht aber der Rahmen 7.

Um benachbarte Massen 2 synchron oszillierend schwingen lassen zu können, sind diese mit Synchronisierfedern 6 verbunden. Diese befinden sich im Spalt zwischen zweier benachbarter Massen 2 und erlauben, dass sich der Spalt zwischen den beiden benachbarten Massen 2 vergrößert und verkleinert, je nachdem ob sich die Massen nahe dem Zentrum des Sensors oder weiter von diesem entfernt befinden. Andererseits weisen die Synchronisierfedern 6 eine Stabilität und Steifigkeit auf, wenn die benachbarten Massen versuchen würden, asynchron zu schwingen. Es wird somit nicht zugelassen, dass sich eine der Massen 2 näher am Zentrum des Sensors befindet als die benachbarte Masse 2.

Die vier Antriebsmassen 2 schwingen wie durch die Doppelpfeile angedeutet ist. Die Gestalt der Massen 2 kann selbstverständlich anders als hier dargestellt sein. So können die Massen beispielsweise eine andere Form aufweisen und insbesondere auch die Antriebselektroden in sich integriert haben. Die Antriebsmassen 2 können elektrostatisch mit Antriebselektroden betätigt werden. Sie können als Gabeln, Kämme oder als parallele Elektroden oder auch andersartig ausgestaltet sein. Die Antriebsbewegung wird überwacht durch Antriebsüberwachungselektroden, welche ebenfalls im Bereich der Massen 2 angeordnet sein können. Sie können hergestellt sein als Kämme oder wiederum als parallele Elektroden oder auch in anderer Form. Durch diese Elektroden wird kontrolliert, dass der Antrieb der Massen 2 ordnungsgemäß und mit einer vorbestimmten Frequenz erfolgt.

Unter jeder der Antriebsmassen 2 sind vorzugsweise Plattenelektroden 8 angeordnet, welche eine Auslenkung um die x- oder y-Achse feststellen.

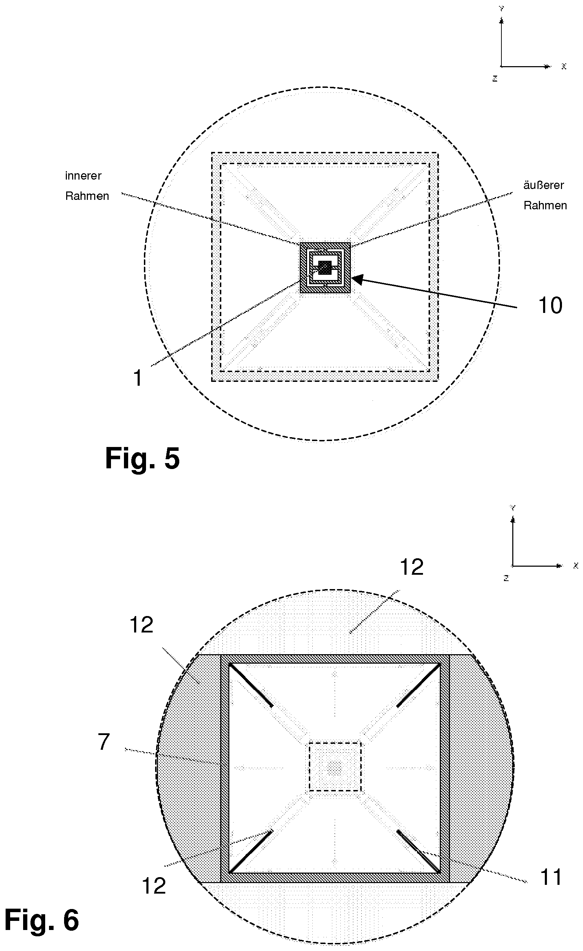

In Figur 5 ist eine Zentralplatte 10 näher dargestellt. Die Zentralplatte 10 ist ähnlich einem Kardangelenk aufgebaut. Sie besteht aus zwei konzentrisch zueinander angeordneten Rahmen, wobei der innere Rahmen an den Zentralanker 1 mit einer in x-Richtung ausgerichteten Feder verbunden ist. Der äußere Rahmen ist mit dem inneren Rahmen über eine in y-Richtung ausgerichtete Feder verbunden. Hierdurch ist es bei entsprechender Ausgestaltung der Federn möglich, dass der äußere Rahmen leichter um die y-Achse schwenkt, während der innere Rahmen zusammen mit dem äußeren Rahmen leichter um die x-Achse schwenkt. Dadurch wird bewirkt, dass die Massen 2 und der Rahmen 7, welche ihrerseits an der Zentralplatte 10, insbesondere an dem äußeren Ring der Zentralplatte 10 befestigt sind, entsprechend um die x-Achse oder y-Achse schwenkbar sind. Corioliskräfte, welche eine derartige Auslenkung bewirken, können somit festgestellt werden. Selbstverständlich kann die Befestigung der Massen 2 auch andersartig an dem Zentralanker 1 erfolgen. Bei entsprechender Ausbildung der Federn ist beispielsweise die direkte Befestigung an dem Zentralanker 1 möglich.

Die Zentralplatte 10 wird benutzt, um die Federn 3 der Antriebsmassen 2 zu befestigen. Bei einer entsprechenden Ausgestaltung der Befestigungsfedern, mit welchen der äußere Rahmen an dem inneren Rahmen und dieser wiederum an dem Zentralanker 1 befestigt ist, kann die Zentralplatte 10 um die x- und um die y-Achse herumschwenken. Die Zentralplatte 10 weist darüber hinaus den Vorteil auf, dass sie äußerst stabil sein kann, insbesondere was Stöße von außen gegen das System betrifft. Sie bewirkt somit eine stabile Lagerung der Massen 2 und des Rahmens 7, ohne dass diese Gefahr laufen, bereits bei leichten Schlägen soweit ausgelenkt zu werden, dass sie auf das Substrat aufschlagen und damit Fehlergebnisse erzeugen. Die Zentralplatte 10 ist an dem Sensorsubstrat über den zentralen Anker 1 befestigt.

In Figur 6 ist der äußere Rahmen 7 des Sensors genauer dargestellt. Der äußere Rahmen 7 ist über die Federn 5 an den bewegten Massen befestigt. Der Rahmen 7 kann auch anders ausgebildet sein, beispielsweise als Ring, wie in Figur 1 und 2, oder auch als Ring- oder Rahmensegment, welche die einzelnen benachbarten Massen 2 miteinander verbinden. Der Rahmen 10 ist mit Rahmenfedern 11 mit dem Substrat verbunden. Die Rahmenfedern 11 sind so ausgebildet, dass sie eine Drehung des Rahmens 10 um die z-Achse erlauben. Sie sind somit bzgl. einer solchen Drehbewegung biegeweich.

Die Rahmenfedern 11 sind an ihrem von dem Rahmen abgewandten Ende mit Federankern 12 an dem Substrat befestigt. Drehungen des Rahmens 7 können mit Rahmensensorelektroden festgestellt werden, welche in der Rahmenperipherie 12 angeordnet sind. Diese Elektroden können als Finger ausgebildet sein, welche radial angeordnet sind oder sie können auch als Kammpaare ausgebildet sein, welche radial angeordnet sind.

Die vorliegende Erfindung ist nicht auf die dargestellten Ausführungsbeispiele beschränkt. Es sind viele andere Ausführungen im Rahmen des Wortlautes der Patentansprüche und der Beschreibung möglich. Auch Kombinationen der Ausführungen einzelner Bauteile der Ausführungsbeispiele sind jederzeit untereinander möglich.

## Patentansprüche

1. Mikro-Gyroskop zur Ermittlung von Rotationsbewegungen um eine x-, y- oder z-Achse,
mit einem Substrat, auf welchem zumindest ein Anker (1) befestigt ist,
mit mehreren oszillierenden Massen (2), wobei die oszillierenden Massen (2) mittels Federn (3) an dem Anker (1) befestigt sind,
mit Antriebselementen zum oszillierenden Schwingen zumindest einzelner dieser Massen (2) in x- Richtung und/ oder weiterer, zumindest einzelner dieser Massen in y-Richtung, um bei einer Auslenkung des Substrats um die x-, y- und/oder z-Achse Corioliskräfte zu erzeugen und mit Sensorelementen, um Auslenkungen der Massen (2) aufgrund der durch die Rotationsbewegungen um die x- und/oder y-Achse erzeugten Corioliskräfte zu erfassen und mit wenigstens einer weiteren Masse (4), wobei die oszillierenden Massen (2) mit der wenigstens einen weiteren Masse (4) verbunden sind, die angetriebenen oszillierenden Massen (2) radial zu dem Anker (1) oszillieren,
die weitere Masse (4) mit den oszillierend angetriebenen Massen (2) derart verbunden ist, dass sie zusammen um den zumindest einen Anker (1) um die z-Achse drehbar sind, die weitere Masse (4) die oszillierend angetriebenen Massen (2) als ein Ring (4) oder ein Rahmen umgibt und
diesem Ring (4) oder Rahmen ein weiteres Sensorelement zugeordnet ist zur Erfassung einer Auslenkung des Substrats um die z-Richtung.

2. Mikro-Gyroskop nach Anspruch 1, **dadurch gekennzeichnet, dass** Sensorelemente zum Erfassen der Auslenkung der oszillierenden Massen (2) unterhalb der oszillierenden Massen (2) angeordnet sind.

3. Mikro-Gyroskop nach einem oder mehreren der vorherigen Ansprüche, **dadurch gekennzeichnet, dass** die weitere Masse mit Biegefedern (11) an dem Substrat befestigt ist.

4. Mikro-Gyroskop nach Anspruch 3, **dadurch gekennzeichnet, dass** die Biegefedern (11) eine Rotation der weiteren Masse um die z-Achse erlauben.

5. Mikro-Gyroskop nach einem oder mehreren der vorherigen Ansprüche, **dadurch gekennzeichnet, dass** der zumindest eine Anker (1) zentral angeordnet ist

6. Mikro-Gyroskop nach Anspruch 5, **dadurch gekennzeichnet, dass** die oszillierenden Massen (2) an dem zentralen Anker (1) befestigt sind.

7. Mikro-Gyroskop nach einem der Ansprüche 5 oder 6, **dadurch gekennzeichnet, dass** zwischen den oszillierenden Massen (2) und dem zentralen Anker (1) eine Zentralplatte (10) angeordnet ist.

8. Mikro-Gyroskop nach Anspruch 7, **dadurch gekennzeichnet, dass** die Zentralplatte (10) an dem Anker (1) nach Art eines Kardangelenkes befestigt sind, um eine Schwenkbewegung der Massen um die x- und y-Achse zu erlauben.

9. Mikro-Gyroskop nach einem der Ansprüche 7 oder 8, **dadurch gekennzeichnet, dass** die oszillierenden Massen (2) mittels Federn (3) an der Zentralplatte (10) befestigt sind.

10. Mikro-Gyroskop nach einem oder mehreren der Ansprüche 1 bis 9, **dadurch gekennzeichnet, dass** die oszillierenden Massen (2) mittels Federn (5) an der weiteren Masse (4) befestigt sind.

11. Mikro-Gyroskop nach einem oder mehreren der vorherigen Ansprüche, **dadurch gekennzeichnet, dass** die oszillierenden Massen (2) mit Synchronisierfedern (6) miteinander verbunden sind.

12. Mikro-Gyroskop nach einem oder mehreren der Ansprüche 7, 8 oder 9, **dadurch gekennzeichnet, dass** die oszillierenden Massen (2) und die weitere Masse und/oder die Zentralplatte (10) drehbar um die z-Achse gelagert sind.

13. Mikro-Gyroskop nach einem oder mehreren der vorherigen Ansprüche, **dadurch gekennzeichnet, dass** die Antriebselemente der oszillierenden Massen (2) Elektroden, insbesondere Gabelelektroden, sind.

## Claims

1. Microgyroscope for determining rotational movements around an x-, y- or z-axis, comprising:
a substrate on which at least one anchor (1) is fastened,
a plurality of oscillating masses (2), each of said oscillating masses (2) being fastened to the anchor (1) by means of springs (3),
driving elements for the oscillating swinging of at least individual ones of said masses (2) in x-direction and/or further at least individual ones of said masses in y-direction, in order to generate Coriolis forces when the substrate is deflected around the x-axis, y-axis and/or z-axis, and sensor elements for detecting the deflections of said masses (2) being caused due to said Coriolis forces generated by the rotational movements around the x-axis and/or the y-axis, and
at least one additional mass (4), whereas
the oscillating masses (2) are connected to the at least one additional mass (4),
the driven oscillating masses (2) oscillate radially in relation to the anchor (1)
the additional mass (4) is connected to the oscillating driven masses (2) such that they are rotatable together around the at least one anchor (1) around the z-axis
the additional mass (4) surrounds the oscillating driven masses (2) as a ring (4) or frame, and
a further sensor element is assigned to said ring (4) or frame for detecting a deflection of the substrate around the z-direction.

2. Microgyroscope according to claim 1 charaterized in that sensor elements for detecting the deflection of the oscillating masses (2) are arranged underneath the oscillating masses (2).

3. Microgyroscope according to one or several of the previous claims **characterized in that** the additional mass is attached to the substrate with bending springs (11).

4. Microgyroscope according to claim 3 **characterized in that** the bending springs (11) allow the additional mass to rotate around the z-axis.

5. Microgyroscope according to one or several of the previous claims **characterized in that** the at least one anchor (1) is centrally arranged.

6. Microgyroscope according to claim 5 **characterized in that** the oscillating masses (2) are fastened to the central anchor (1).

7. Microgyroscope according to one of the claims 5 or 6 **characterized in that** a central disk (10) is arranged between the oscillating masses (2) and the central anchor (1).

8. Microgyroscope according to claim 7 **characterized in that** the central disk (10) is fastened to the anchor (1) in the manner of a universal joint to allow the masses to swing around the x- and the y-axis.

9. Microgyroscope according to one of the claims 7 or 8 **characterized in that** the oscillating masses (2) are fastened with springs (3) to the central disk (10).

10. Microgyroscope according to one or several of the claims 1 to 9 **characterized in that** the oscillating masses (2) are fastened with springs (5) to the additional mass (4).

11. Microgyroscope according to one or several of the previous claims **characterized in that** the oscillating masses (2) are connected to one another with synchronizing springs (6).

12. Microgyroscope according to one or several of the claims 7, 8, or 9 **characterized in that** the oscillating masses (2) and the additional mass and/or the central disk (10) are mounted pivotably around the z-axis.

13. Microgyroscope according to one or several of the previous claims **characterized in that** the driving elements of the oscillating masses (2) are electrodes, especially fork-shaped electrodes.

## Revendications

1. Micro-gyroscope pour déterminer des mouvements de rotation autour d'un axe x, y ou z,
avec un substrat sur lequel est fixé au moins une ancre (1),
avec plusieurs masses oscillantes (2), sachant que les masses oscillantes (2) sont fixées sur l'ancre (1) à l'aide de ressorts (3),
avec des éléments d'entraînement pour l'oscillation d'au moins certaines masses individuelles de ces masses (2) dans le sens x et/ou d'autres, au moins certaines masses individuelles de ces masses dans le sens y pour générer des forces de Coriolis en cas de déviation du substrat autour de l'axe x, y et/ou z et
avec des éléments capteurs pour capter les déviations des masses (2) en raison des forces de Coriolis générées par les mouvements de rotation autour de l'axe x et/ou y et
avec au moins une masse supplémentaire (4), sachant que les masses oscillantes (2) sont reliées avec l'au moins une masse supplémentaire (4),
les masses entraînées en oscillations (2) oscillent radialement par rapport à l'ancre (1),
la masse supplémentaire (4) est reliée avec les masses entraînées en oscillations (2) de manière à ce qu'elles soient conjointement rotatives autour de l'au moins une ancre (1) autour de l'axe z,
la masse supplémentaire entoure les masses entraînées en oscillations (2) en tant qu'anneau (4) ou cadre et
un élément capteur supplémentaire est attribué à cet anneau (4) ou ce cadre pour capter une déviation du substrat dans le sens z.

2. Micro-gyroscope selon la revendication 1, **caractérisé en ce que** des éléments capteurs pour la saisie de la déviation des masses oscillantes (2) sont disposés sous les masses oscillantes (2).

3. Micro-gyroscope selon l'une ou plusieurs des revendications précédentes, **caractérisé en ce que** la masse supplémentaire est fixé sur le substrat au moyen de ressorts de flexion (11).

4. Micro-gyroscope selon la revendication 3, **caractérisé en ce que** les ressorts de flexion (11) permettent une rotation de la masse supplémentaire autour de l'axe z.

5. Micro-gyroscope selon l'une ou plusieurs des revendications précédentes, **caractérisée en ce que** l'au moins une ancre (1) est disposée à une position centrale.

6. Micro-gyroscope selon la revendication 5, **caractérisé en ce que** les masses oscillantes (2) sont fixées à l'ancre centrale (1).

7. Micro-gyroscope selon l'une des revendications 5 ou 6, caractérisé en ce qu'une plaque centrale (10) est disposée entre les masses oscillantes (2) et l'ancre centrale (1).

8. Micro-gyroscope selon la revendication 7, **caractérisé en ce que** la plaque centrale (10) est fixée sur l'ancre (1) à la manière d'une articulation à cardan afin de permettre un mouvement de pivotement des masses autour des axes x et y.

9. Micro-gyroscope selon l'une des revendications 7 ou 8, **caractérisé en ce que** les masses oscillantes (2) sont fixées sur la plaque centrale (10) à l'aide de ressorts (3).

10. Micro-gyroscope selon l'une ou plusieurs des revendications 1 à 9, **caractérisé en ce que** les masses oscillantes (2) sont fixées sur la masse supplémentaire (4) à l'aide de ressorts (5).

11. Micro-gyroscope selon l'une ou plusieurs des revendications précédentes, **caractérisé en ce que** les masses oscillantes (2) sont reliées les unes avec les autres par des ressorts de synchronisation (6).

12. Micro-gyroscope selon l'une ou plusieurs des revendications 7, 8 ou 9, **caractérisé en ce que** les masses oscillantes (2) et la masse supplémentaire et/ou la plaque centrale (10) sont montées sur palier rotatif autour de l'axe z.

13. Micro-gyroscope selon l'une ou plusieurs des revendications précédentes, **caractérisé en ce que** les éléments d'entraînement des masses oscillantes (2) sont des électrodes, en particulier des électrodes en fourche.
